# EUROPEAN PATENT APPLICATION

(11) **EP 4 535 959 A1**
(43) Date of publication of application: **09.04.2025**
(21) Application number: 24198889.8
(22) Date of filing: 06.09.2024
(51) Int. Cl.: H10F 19/90, H10F 99/00

(54) **PHOTOVOLTAIC MODULE WITH IMPROVED PHOTOVOLTAIC CELL INTERCONNECTION CONDUCTIVITY AND RELATED MANUFACTURING PROCESS**

(30) Priority: 08.09.2023 IT 202300018486
(71) Applicant: 3SUN S.R.L., 95121 Catania (IT)
(72) Inventor: MAUGERI, Benedetto, 95121 CATANIA (IT); RUSSO, Francesco, 95121 CATANIA (IT); IZZO, Gaetano, 95121 CATANIA (IT); GERARDI, Cosimo, 95121 CATANIA (IT); CARBONE, Lorenzo, 00124 ROMA (IT)
(74) Representative: Studio Torta S.p.A.

(57) **Abstract**

Photovoltaic module (19) including at least one string (2) including at least one first and one second photovoltaic cell (11, 12) and a connector (S) that electrically couples the first and the second photovoltaic cell. The first and the second photovoltaic cells each comprise: a respective photovoltaic conversion region (10) delimited by a respective main front surface (10a) and a respective main rear surface (10b) opposite to each other; and a respective first electrode structure (15) and a respective second electrode structure (25), which are formed of conductive material and extend respectively on the first and on the main rear surface (10a, 10b) . The photovoltaic module is characterised in that the connector (S) is made of a composite material comprising a support matrix and electrically conductive particles, which are dispersed in the thermoplastic polymer matrix. The connector further includes a respective first end portion (55) and a respective second end portion (57), which respectively contact the second electrode structure of the first photovoltaic cell and the first electrode structure of the second photovoltaic cell.

## Description

### CROSS-REFERENCE TO RELATED APPLICATIONS

This patent application claims priority from Italian patent application no. 102023000018486 filed on September 8, 2023, the entire disclosure of which is incorporated herein by reference.

### Technical field

The present invention relates to a photovoltaic module with improved photovoltaic cell interconnection conductivity and to the related manufacturing process.

### Background

A photovoltaic cell is a device capable of converting solar energy into electrical energy by exploiting the photoelectric effect at a junction of regions made of semiconductive material, such as crystalline silicon (c-Si), having opposite doping (P and N). More specifically, photovoltaic cells made with Hetero Junction Technology (HJT) of amorphous and crystalline silicon (typically known as "intrinsic layer", I, as it is not doped), and with bifacial operation, allow to achieve industrial-scale conversion efficiencies of up to 24.5%, and a robustness that allows life cycles even longer than thirty years. HJT solar cells are therefore today's most widespread choice for assembling photovoltaic modules that are increasingly efficient and competitive in many respects, such as production costs, generated power, average lifetime and adaptability to operation even in extreme climatic conditions.

A photovoltaic module (or simply "module") houses a plurality of photovoltaic cells (or simply "cells") arranged and connected to each other in such a way as to obtain, as an output from the module, predetermined electrical characteristics. Electrical connections of cells, typically in mixed series-parallel schemes, are implemented in order to obtain a maximum supply voltage and a maximum current that can be supplied to an external load, coupled to the module. The connections between the cells, and thus the associated interconnections, are typically made by means of "wire" or "ribbon" connectors made of conductive material that connect opposite faces of consecutive cells to each other. The connectors are typically made of metallic material, such as copper or silver, optionally coated with soldering alloys, and are coupled to the cell faces in specific positions, e.g. by bonding or soldering.

Consecutive cells are connected to each other to form cell strings (or simply "strings"). The module typically comprises a plurality of strings, placed side-by-side, in a number varying, for example, between six and ten, and each string may comprise a number of cells for example, between six and twenty, resulting in cells arranged within the module in rows and columns (with a total number of cells, for example, between sixty and one hundred and twenty). The connection of the cells along the strings, e.g. by means of ribbon connectors, not only implements the desired circuit diagram for the module, but also enables to collect and convey the current photogenerated by each cell. The creation of the interconnections is therefore a critical step in the processes for assembling the modules, as it can directly affect the conversion efficiency thereof.

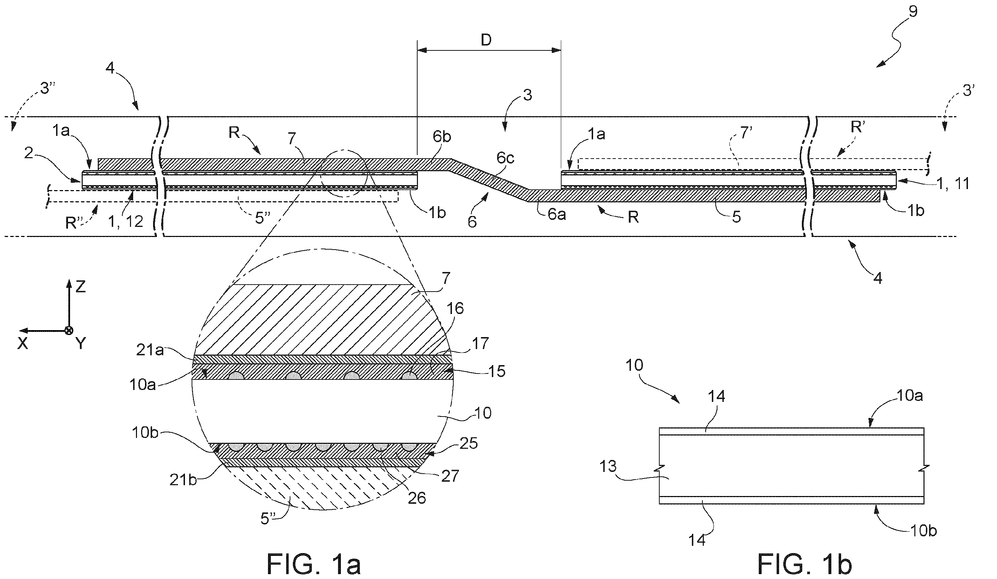

Figure 1a shows the typical electrical connection between consecutive cells 1 within a string 2 of a photovoltaic module 9 (two shown in Figure 1a). Considering a reference system of orthogonal axes X, Y, Z, the string 2 extends along the axis X; furthermore, Figure 1a shows a cross-section of the cells 1 in a plane parallel to the plane XZ. Cells 1 are planar in shape, each having a first face 1a and a second face 1b opposite to each other along the axis Z, and may be rectangular (with typical dimensions of, for example, 105×210 mm respectively along the axes X and Y) or square (e.g. 210×210 mm). Cells 1 are oriented, with respect to the axis Z, in the same way, such that the mutual arrangement, along the axis Z, of the first and of the second face 1a, 1b does not vary as the cell being considered varies.

Figure 1a shows a pair of consecutive cells 1 of the string 2 comprising a first cell 11 and a second cell 12, which are identical to each other and separated along the axis X by a corresponding intercell region 3. The intercell regions 3 (one shown in Figure 1a) of the string 2 are portions of an encapsulation region 4 of the photovoltaic module 9 in which the cells 1 are embedded. The encapsulation region 4 (typically formed of a plastic material) extends with a planar form parallel to the plane XY over the entire dimension of the module 9, contains the strings 2 of the module 9 and has a thickness along the axis Z of, for example, 0.9 mm.

Each intercell region 3 extends parallel to the axis Y and separates, along the axis X, consecutive pairs of cells 1 of a same string 2 by an intercell distance D, comprised in the range 1mm - 6mm and equal to, for example, 4mm. The intercell distance D is maintained when assembling the module 9 to accommodate the connection between consecutive cells 1 of a same string 2.

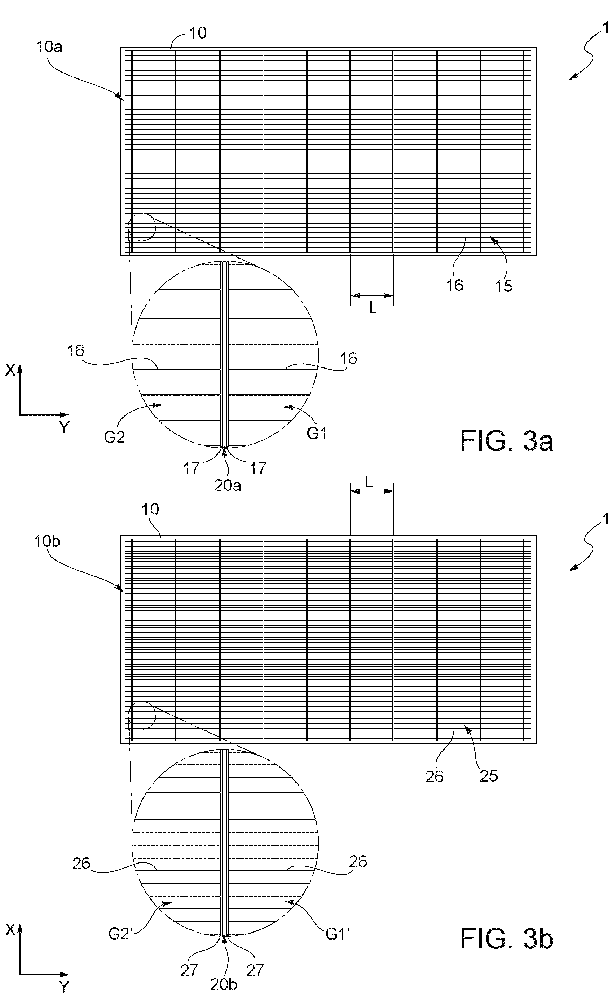

With reference to the enlarged detail in Figure 1a, Figures 3a and 3b and their respective enlarged details, each cell 1 comprises a conversion layer 10, a first conductive structure 15 and a second conductive structure 25.

The conversion layer 10 is provided with a main front surface 10a and a main rear surface 10b, which are opposite to each other along the axis Z direction, and typically comprises at least one semiconductive area 13 and two conductive films 14 (the latter formed of the so-called TCO - Transparent Conductive Oxide), as shown in Figure 1b. The semiconductive area 13 is interposed between the two conductive films 14 and comprises a multilayer structure of materials (e.g. c-Si) with different and/or opposite doping, forming at least one junction; the materials may have different band gaps, as in the case of HJT heterojunction cells (with a P-I-N/N-I-P multilayer structure). The semiconductor area 13 represents the active area of the cell, wherein the photons are absorbed at the junction, generating charge carriers that give rise to the photogenerated current. The conductive films 14 are thin layers that have, at the same time, anti-reflective properties for the incident radiation and conductive properties, and are deposited (e.g. by PVD - Physical Vapour Deposition) on opposite faces of the semiconductive area 13. The conductive films 14 are therefore delimited in the cell 1 respectively by the main front surface 10a and the main rear surface 10b of the conversion layer 10. The conversion layer 10 is therefore a wafer that is formed according to known semiconductor industry techniques and is diced with dimensions according to the cells 1. The conversion layer 10 extends over a thickness along the axis Z of, for example, 0.16mm.

The charge carriers generated along the entire dimension of the semiconductive area 13 of the conversion layer 10 are collected from the first and from the second conductive structure 15, 25. In detail, referring to Figures 3a and 3b, the first and the second conductive structure 15, 25 are metal grids that are formed respectively in contact with the main front surface 10a and the main rear surface 10b of the conversion layer 10 and form respectively a first electrical terminal (e.g. positive) and a second electrical terminal (e.g. negative) for each cell 1, through which the photogenerated current can flow.

In a bifacial HJT cell, both the main front surface 10a and the main rear surface 10b of the conversion layer 10 may receive light radiation; for example, the main front surface 10a may be the side of the cell 1 that is exposed to direct solar radiation, while the main rear surface 10b may be the side of cell 1 that receives scattered radiation from the ground or other surfaces near the module 9 (referred to as "albedo"). That being said, the first and the second conductive structures 15, 25 may differ from each other in terms of exposure requirements and thus of maximisation of incident light radiation; the metal grid of the first conductive structure 15 has, for example, a broader frame than the metal grid of the second conductive structure 25.

The first and the second conductive structures 15, 25 are respectively formed on the conductive films 14, by screen printing techniques and are made of a conductive material, typically a metal, more specifically silver, copper or metal alloys with a prevailing silver and/or copper content.

The first and the second conductive structures 15, 25 comprise respective pluralities of first electrodes (known as "fingers"), respectively referred to as 16 and 26, with an elongated shape parallel to the axis Y and laterally and periodically spaced apart along the axis X so as to leave the conversion layer 10 substantially exposed to the incident radiation. As mentioned, the first electrodes 16 of the first conductive structure 15 are typically offset along the axis X with a greater pitch than the first electrodes 26 of the second conductive structure 25. The first electrodes 16 of the first conductive structure 15 are identical to each other; the first electrodes 26 of the second conductive structure 25 are identical to each other and may be different from the first electrodes 16 of the first conductive structure 15. As a first approximation, the first electrodes 16, 26 run, parallel to the axis Y, along the entire dimension of each cell 1.

The first and the second conductive structures 15, 25 further comprise respective pluralities of pairs of second electrodes (known as "busbars"), respectively referred to as 17, 27, and having elongated shapes parallel to the axis X.

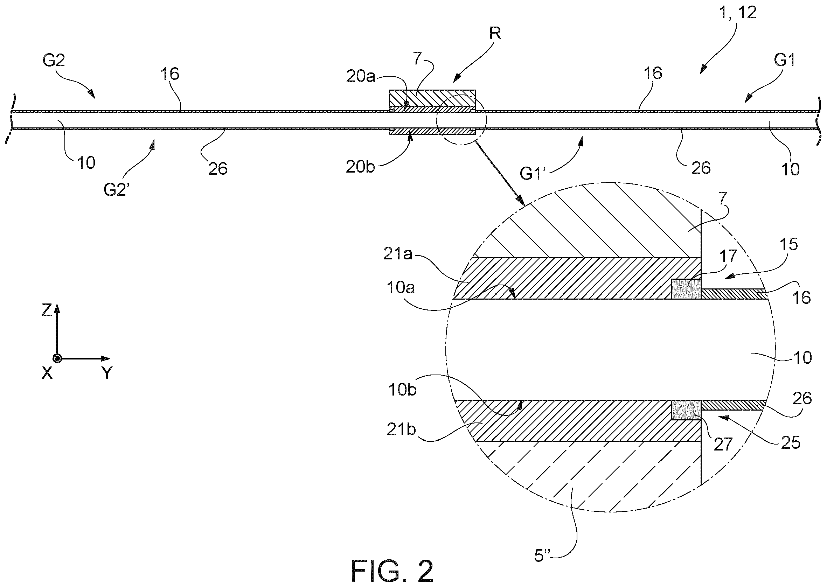

In detail, referring for the sake of brevity only to the second electrodes 17 of the first conductive structure 15, to the first electrodes 16 and to the main front surface 10a (the same considerations apply to the second electrodes 27 of the second conductive structure 25, to the first electrodes 26 and to the main rear surface 10b), the second electrodes 17 are equal to each other and form pairs of second electrodes 17 that are equal to each other. In addition, each pair of second electrodes 17 of the first conductive structure 15 is arranged on the main front surface 10a, in direct contact, and is interposed between corresponding pairs of portions of first electrodes 16; in particular, the second electrodes 17 of the pair are laterally offset along the axis Y. More particularly, one of the second electrodes 17 of the pair contacts laterally, on a first side thereof, a first group G1 of corresponding portions of first electrodes 16; the other second electrode 17 of the pair contacts laterally, on a second side thereof, a second group G2 of corresponding portions of first electrodes 16, the second side being opposite to the first side, so that the first and the second group G1, G2 are symmetrical with respect to the pair of second electrodes 17. Each first electrode 16 is thus formed of a plurality of corresponding portions, separated from each other, as shown in Figure 2 (in which the encapsulation region 4 is omitted for the sake of simplicity); furthermore, each portion of first electrode 16 contacts, at its ends, two corresponding second electrodes 17, which respectively belong to two consecutive pairs. The same considerations apply to the second conductive structure 25 and the main rear surface 10b, with corresponding first and second groups G1', G2' of portions of first electrodes 26.

Each pair of second electrodes 17 of the first conductive structure 15 is vertically aligned, parallel to the axis Z, with a pair of second electrodes 17 of the second conductive structure 25; however, the distance along the axis Y between the electrodes of the pairs of second electrodes 17 on the main front surface 10a may differ from the distance between the electrodes of the pairs of second electrodes 27 on the main rear surface 10b. For example, the pairs of second electrodes 17, 27 are spaced apart along the axis Y by a connection distance L in the range of 8 - 30 mm and equal to, for example, 21 mm; furthermore, second electrodes 17, 27 of each pair are spaced apart by a distance in the range of 0.1 - 1.2 mm, even more specifically in the range of 0.4 - 0.9 mm and equal to, for example, 0.6 mm. Furthermore, the first electrodes 16, 26 and the second electrodes 17, 27 can have thicknesses along the axis Z respectively in the ranges of 0.005 - 0.020 mm and 0.050 - 0.070 mm and equal to, for example, 0.01 mm and 0.06 mm. Furthermore, first adjacent electrodes 16 of the first conductive structure 15 are separated from each other along the axis X by a distance of e.g. 0.6 mm to 1.2 mm; first adjacent electrodes 26 of the second conductive structure 25 are separated from each other along the axis X by a distance of e.g. 0.2 mm to 0.8 mm.

For practical purposes, the second electrodes 17, 27 perform a function of collecting the charge carriers conveyed by the respective portions of first electrodes 16, 26. The second electrodes 27 of the second conductive structure 25 may be different from the second electrodes 17 of the first conductive structure 15. In addition, the second electrodes 17, 27 run, parallel to the axis X, along almost the entire dimension of each cell 1.

For practical purposes, the first and the second conductive structures 15, 25 can be formed from different screen prints in order to provide, as mentioned, a desired frame width. Furthermore, in each cell 1, the respective first face 1a is formed of the respective first conductive structure 15 and of the portions of the main front surface 10a left exposed by the respective first conductive structure 15, while the respective second face 1b is formed of the respective second conductive structure 25 and of the portions of the main rear surface 10b left exposed by the respective second conductive structure 25.

Referring again, for the sake of brevity, only to the second electrodes 17 of the first conductive structure 15 and to the main front surface 10a (the same considerations apply to the second electrodes 27 of the second conductive structure 25 and to the main rear surface 10b), each pair of second electrodes 17 laterally delimits a corresponding connection cavity 20a, which is delimited at the bottom by a corresponding portion of the main front surface 10a. Similarly to what has been described with reference to the second electrodes 17 of the first conductive structure 15, each pair of second electrodes 27 of the second conductive structure 25 delimits laterally a corresponding connection cavity 20b, which is delimited at the top by a corresponding portion of the main rear surface 10b.

Still referring to Figure 1a, the electrical connection between the first cell 11 and the second cell 12 of the string 2 is made by means of a plurality of connectors R (only one shown), e.g. ribbon-shaped and equal to each other, each connector R being associated with a corresponding pair of second electrodes 27 of the first cell 11 and with a corresponding pair of second electrodes 17 of the second cell 12. A single connector R is described hereinafter.

The connector R extends parallel to the axis X and is embedded in the encapsulation region 4. In addition, the connector R comprises a first end portion 5, a second end portion 7 and a coupling portion 6 that connects the first and the second end portions 5, 7. The coupling portion 6 extends between the first and the second cell 11, 12 in the respective intercell region 3. The first and the second end portions 5, 7 extend respectively below the second face 1b of the first cell 11 and above the first face 1a of the second cell 12. The first and the second end portions 5, 7 have an elongated shape parallel to the axis X and extend approximately over the entire dimension, along the axis X, of the first cell 11 and second cell 12. That being said, since the first and the second cell 11, 12 are coplanar, i.e. arranged in the encapsulation region 4 at the same height, along the axis Z, the first and the second end portions 5, 7 are arranged at different heights from each other and in particular are spaced apart, along the axis Z, by a distance equal to the thickness of a cell 1.

The coupling portion 6 of the connector R comprises a first lateral part 6a, a second lateral part 6b and an oblique part 6c connecting the first and the second lateral parts 6a, 6b.

The first and the second lateral parts 6a, 6b have an elongated shape parallel to the axis X and form extensions of the first and, respectively, of the second end portions 5, 7, which they are respectively coaxial to. In detail, the first lateral part 6a connects the first end portion 5 and the oblique part 6c of the coupling portion 6; the second lateral part 6b connects the second end portion 7 and the oblique part 6c of the coupling portion 6; the oblique part 6c has an elongated shape and is inclined with respect to the first and the second lateral parts 6a, 6b. As a whole, the coupling portion 6 of the connector R has, in cross-section, an approximately S-shaped profile.

Each connector R makes a serial electrical connection between the first and the second cell 11, 12. In fact, each connector R connects the second conductive structure 25 of the first cell 11 (i.e. the respective negative terminal) to the first conductive structure 15 of the second cell 12 (i.e. the respective positive terminal).

Figure 1a also shows, in hatching, end portions of two further connectors referred to as R' and R") adjacent to the connector R. In particular, a second end portion 7' of the connector R' (above the first cell 11) and a first end portion 5" of the connector R" (below the second cell 12) are shown. Connector R' and connector R'' belong to corresponding pluralities of connectors that electrically connect, respectively, the first and the second cell 11, 12 to adjacent cells 1 (not shown) of the string 2 and comprise extensions in corresponding intercell regions 3', 3'' adjacent to the intercell region 3.

In practice, each cell 1 of the module 9 has, on opposite faces, end portions of corresponding connectors.

Still referring to a single connector R, the second end portion 7 extends above the corresponding pair of second electrodes 17 of the first conductive structure 15 of the second cell 12, to which it is electrically coupled by interposition of a respective connection layer 21a, which fills the corresponding connection cavity 20a; the first end portion 5 (not visible in Figure 2) extends below a corresponding pair of second electrodes 27 of the second conductive structure 25 of the first cell 11, to which it is electrically coupled by interposition of a respective connection layer 21b, which fills the corresponding connection cavity 20b.

In practice, the first end portions 5 of the connectors R are arranged periodically along the axis Y, with a periodicity equal to the connection distance L; the second end portions 7 of the connectors R are also arranged periodically along the axis Y, with a periodicity equal to the connection distance L. Furthermore, each connector R has a width, along the axis Y, approximately coincident with the aforementioned distance between second electrodes 17, 27 of each pair. The connectors R, when viewed in the plane XZ, have a ribbon shape, resulting in the term by which they are commonly referred to (ribbon).

In addition to creating the electrical connection between pairs of consecutive cells 1 of a same string 2, the connectors collect and convey the charge carriers generated over the entire dimension of a single cell 1.

The connection layers 21a, 21b are typically formed using electrically conductive adhesives, or ECAs for the sake of brevity, i.e. composite materials based on a thermosetting polymer matrix to which electrically conductive additives (also known as "fillers") are added.

In the process of forming electrical connections within a same cell 1 and between consecutive cells 1 of the photovoltaic module 9, the connection layers 21a, 21b are deposited in the respective connection cavities 20a, 20b in a step prior to the formation of the respective connectors. The connection layers 21a, 21b allow the bonding of the respective connectors to the first and to the second conductive structures 15, 25.

The polymer matrix of the ECA typically comprises materials such as epoxy resins and/or acrylic and silicone pastes that, at room temperature, have a viscosity such that they can be deposited, in a first process step, by means of screen printing, for example. The electrically conductive additives provide the desired electrical properties to the connection layers 21a, 21b and can be metal particles dispersed in the polymer matrix, such as particles (e.g. nanospheres and/or microspheres) of silver, in concentrations in the range of e.g. 300 - 650 of the total volume of the ECA.

The strings 2 of the module 9 are assembled, in a second process step, using dedicated machines known as stringers. A stringer machine receives the incoming cells 1 and, starting from wire coils of metallic material, deposits the connectors according to the electrical and mechanical scheme described above. A stringer further provides a unit for flipping photovoltaic cells and their groups. In particular, referring to the connector R, and with the simplifying assumption that the first cell 11 is the initial cell of the string 2, the first cell 11 is initially received by the stringer upside down with respect to the axis Z, i.e. with the second face 1b overlying the first face 1a; the first end portion 5 of the connector R is then deposited above the second face 1b of the first cell 11 until the first lateral part 6a of the coupling portion 6 is formed; the first cell 11 is then flipped, and the remaining parts of the coupling portion 6 are formed; finally, the second end portion 7 is deposited above the first face 1a of the second cell 12. The process can then be repeated, starting by flipping the group comprising the first and the second cell 11, 12 and by forming the first end portion 5" of the connector R" consecutive to the connector R.

Since the ECA matrix is a thermosetting material, it must be activated (or sintered) in order to exhibit the final polymeric structure: activation typically comprises one or more thermosetting, or curing steps, e.g. by exposure to infrared radiation. In a third step, thus, each string 2 of the module 9 assembled in the second step is passed in special ovens with dedicated temperatures and exposure times, in order to complete the process of coupling (bonding) the connectors to the cells 1.

In HJT photovoltaic cells, the amorphous silicon layers of the semiconductive area exhibit a high deterioration when exposed to temperatures above 220°C, even for relatively short times. The process of forming the electrical connections of HJT cells therefore provides using techniques and materials that take into account the characteristics of the photovoltaic technology adopted to ensure the designed conversion performance. Compared to soldering techniques, in order to couple the connectors to the cells, it is preferable to use the above-mentioned electrically conductive adhesives, which cure at temperatures (typically between 130°C and 180°C) lower than the critical temperatures for HJT cells, reducing the risk of damage to the most sensitive layers.

However, the use of ECA materials as bonding agents between the connectors and the conductive structures of the cells, in addition to being expensive due to the relative market cost, leads to the formation of a considerable number of electrical interfaces that the charge carriers, generated in the cells and collected by the connectors, have to pass through. In particular, the electrical interfaces created by the presence of the ECA can be critical in terms of the ohmic resistance seen by the charge carriers, reducing the conductivity of the cells and ultimately the conversion efficiency of the entire module.

Furthermore, the use of machines such as stringers can affect the cost of assembling cell strings due to their complexity of use and their market cost.

The aim of the present invention is thus to provide a solution that at least partially overcomes the disadvantages and limitations of the prior art.

### Summary

According to the present invention, a photovoltaic module and the related manufacturing process are disclosed as defined in the appended claims.

### Brief description of the Figures

For a better understanding of the present invention, some preferred embodiments thereof will now be disclosed, for merely illustrative and non-limiting purposes, with reference to the enclosed drawings, wherein:
- Figure 1a schematically shows a cross-section of a photovoltaic module, and an enlarged detail thereof, according to the state of the art;
- Figure 1b schematically shows, in a cross-section, the inner structure of a photovoltaic cell of the photovoltaic module in Figure 1a;
- Figure 2 schematically shows a cross-section with removed portions of a portion of a photovoltaic cell of the photovoltaic module of Figure 1a;
- Figures 3a and 3b schematically show views, from above and below respectively, of opposite faces of the photovoltaic cell in Figure 2;
- Figure 4a schematically shows a cross-section of a photovoltaic module according to an embodiment of the present invention;
- Figures 4b and 4d schematically show enlarged details with portions removed of two distinct portions of the photovoltaic module of Figure 4a;
- Figure 4c schematically shows an enlarged detail with portions removed of a cross-section of a portion of the photovoltaic module of Figure 4a, taken along a section line IVc-IVc visible in Figure 4a;
- Figure 4e schematically shows an enlarged detail with portions removed of a cross-section of a portion of the photovoltaic module of Figure 4a, taken along a section line IVe-IVe visible in Figure 4a;
- Figure 5 schematically shows a perspective view of an extrusion-based fused deposition modelling printer;
- Figures 6a-6e schematically show consecutive steps of a manufacturing process of the photovoltaic module of Figure 4a;
- Figure 7a schematically shows a cross-section, taken along a section line corresponding to that of Figure 4b, of a portion of a photovoltaic module according to a different embodiment; and
- Figure 7b schematically shows a cross-section, taken along a section line corresponding to that of Figure 4c, of a portion of the photovoltaic module according to the embodiment of Figure 7a.

### Description of embodiments

The following description refers to the arrangement shown in the drawings; consequently, expressions such as "above", "below", "upper", "lower", "at the top", "at the bottom", "on the right", "on the left" and the like relate to the enclosed Figures and should not be interpreted in a limiting manner.

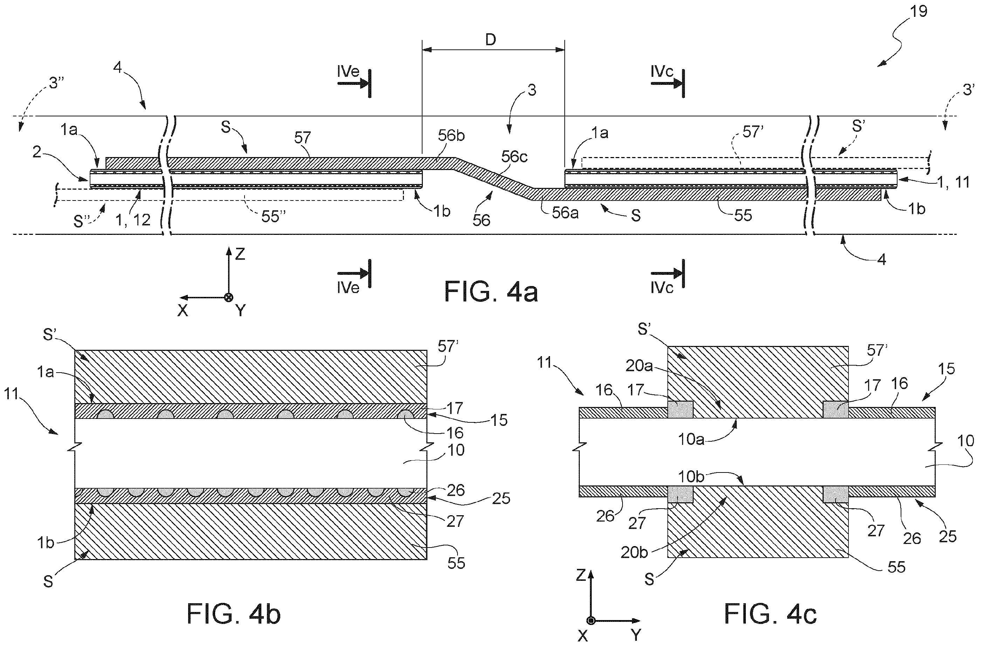

Figures 4a-4c show a photovoltaic module 19, according to a first embodiment, which is described hereinafter referring to the differences with respect to the photovoltaic module 9 shown in Figure 1a. Elements that are already present in the photovoltaic module 9 are indicated with the same reference numbers, unless otherwise indicated.

In detail, the photovoltaic module 19 comprises a plurality of connectors equal to each other, said plurality comprising a first, second and third connector S, S', S", visible in Figure 4a. Each of the first, second and third connectors S, S', S" belongs to a corresponding group of connectors arranged periodically along the axis Y, similarly to what has been described with reference to connectors R, R' and R", each group being interposed between a corresponding pair of consecutive cells. The first connector S is described hereinafter.

The first connector S lies approximately in a respective plane parallel to the plane XZ and comprises a first end portion 55, a second end portion 57 and a coupling portion 56 connecting the first and the second end portions 55, 57. The coupling portion 56 extends into the intercell region 3 existing between the first and the second cell 11, 12, with an approximately S shape (when viewed in a plane parallel to the plane XZ).

The first and the second end portions 55, 57 have an elongated shape parallel to the axis X and extend approximately over the entire dimension, along the axis X, of the first and of the second cell 11, 12. Along the axis Z, the first and the second end portions 55, 57 have thicknesses of between 0.1mm and 0.25mm, for example. Along the axis Y, the first and the second end portions 55, 57 have a width of between 0.1mm to 1.2mm; without losing generality, the first connector S therefore has a "ribbon" shape.

In more detail, as visible in Figure 4c, the first end portion 55 fills the corresponding connection cavity 20b, in direct contact with the corresponding pair of second electrodes 27 and with the overlying main rear surface portion 10b, which delimits the connection cavity 20b at the top. For each second electrode 27 of the pair, the first end portion 55 thus coats the side of the second electrode facing the other second electrode of the pair; in addition, the first end portion 55 thus coats the second electrodes 27 of the pair at the bottom.

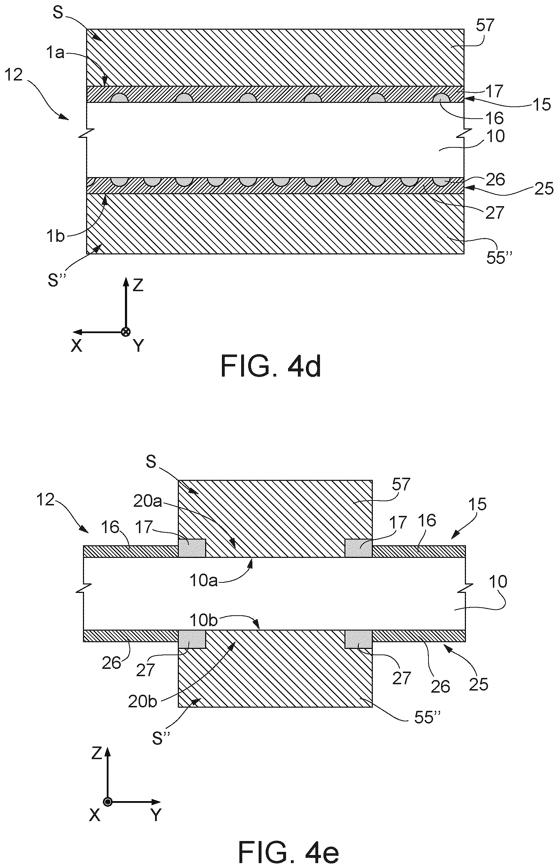

Moreover, as visible in Figures 4d and 4e, the second end portion 57 of the first connector S fills the corresponding connection cavity 20a, in direct contact with the corresponding pair of second electrodes 17 and with the underlying main front surface portion 10a that delimits the connection cavity 20a at the bottom. For each second electrode 17 of the pair, the second end portion 57 thus coats the side of the second electrode facing the other second electrode of the pair; furthermore, the second end portion 57 coats at the top the second electrodes 17 of the pair.

The coupling portion 56 has approximately the same thickness as the first and the second end portions 55, 57 and comprises a first lateral part 56a, a second lateral part 56b and an oblique part 56c connecting the first and the second lateral parts 56a, 56b. The first and the second lateral parts 56a, 56b have an elongated shape parallel to the axis X and form extensions of the first, and respectively, of the second end portions 55, 57, which they are approximately coaxial to. In detail, the first lateral part 56a connects the first end portion 55 and the oblique part 56c of the coupling portion 56 to each other; the second lateral part 56b connects the second end portion 57 and the oblique part 56c of the coupling portion 56 to each other; the oblique part 56c is therefore inclined with respect to the first and to the second lateral parts 56a, 56b and also has an elongated shape.

In more detail, the first connector S is formed of a composite material comprising a thermoplastic polymer matrix housing at least one electrically conductive additive, or "filler".

The composite material exhibits a polymer structure at room temperature and does not need to be activated by means of polymerisation reactions.

The thermoplastic polymer matrix provides adequate mechanical strength and durability properties to the first connector S. The electrically conductive additive is formed of conductive particles dispersed in the thermoplastic polymer matrix and gives the first connector S the ability to conduct electrical charges.

In particular, the thermoplastic polymer matrix exhibits a fusion temperature that may be lower than 220°C, preferably lower than 200°C, even more preferably lower than 180°C. Even more particularly, the thermoplastic polymer matrix may be formed of one or more of the following materials: a polystyrene (PS-based material, such as High-Impact PolyStyrene (HIPS)); Styrene-Acrylonitrile-Copolymer (SAN); PolyMethylMethacrylate (PMMA); Polycarbonate (PC); PolyLactic Acid (PLA); a natural polymer. The thermoplastic polymer matrix can also be formed of one or more natural rubbers and/or one or more synthetic rubbers, such as: a vulcanized rubber; a chloroprene rubber; an epichlorohydrin rubber; a fluoroelastomeric rubber; a hydrogenated nitrile rubber; a nitrile rubber; a perfluoroelastomeric rubber; a polyacrylic rubber. The thermoplastic polymer matrix may also be formed of one or more silicone rubbers comprising polymers of: styrene; butadiene; olefins; esters; amides; urethane. In addition, the thermoplastic polymer matrix can be amorphous or semi-crystalline.

The conductive particles that form the electrically conductive additive can be roughly in the form of microspheres or nanospheres, with diameters between 40nm and 2µm, for example. The particles can be formed of one or more metals and/or metal alloys; for example: silver (Ag); copper (Cu); steel alloys; tin (Sn); tin alloys; antimony alloys (Sb); bismuth alloys (Bi). Electrically conductive additives can also be carbon compounds, such as: graphite; graphene; carbon nanotubes; "hard" and "soft carbon".

The concentration of the electrically conductive additive can, for example, be in the range of 250 - 650 of the total volume of the composite material and can vary depending on the material forming the thermoplastic polymer matrix. For example, when using the thermoplastic polymer acrylate, such as the polymer 1,6-hexanediol diacrylate, an additive comprising silver microspheres can be used in concentrations between 400 - 650, in particular of 600.

As previously mentioned, the second connector S' is the same as the first connector S and has a respective first end portion (not shown) and a respective second end portion (indicated with 57' in Figure 4a) extending on the first face 1a of the first cell 11; furthermore, the second connector S' electrically connects the first cell 11 with an adjacent cell (not shown, but arranged on the right of the first cell 11 in Figure 4a) of the string 2, in the same way as the first connector S electrically connects the first and the second cells 11, 12.

As previously mentioned, the third connector S" is the same as the first connector S and has a respective first end portion (indicated with 55" in Figure 4a), which extends on the second face 1b of the second cell 12, and a respective second end portion (not shown); in addition, the third connector S" electrically connects the second cell 12 with an adjacent cell (not shown, but arranged on the left of the second cell 12 in Figure 4a) of the string 2, in the same way as the first connector S electrically connects the first and the second cell 11, 12.

The connectors of the photovoltaic module 19 can be formed by means of 3D printing techniques, preferably using extrusion-based Fused Deposition Modelling (FDM).

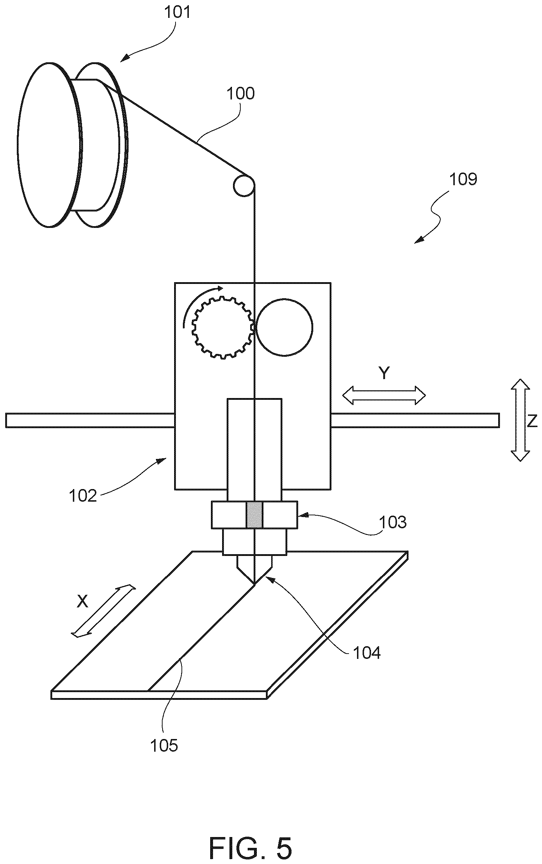

In particular, as shown in Figure 5, FDM provides to extract a filament 100, e.g. of a thermoplastic material, from a spool 101 of a printer 109 and to insert the filament 100 into an extruder 102 of the printer 109, which comprises a fusion chamber 103. In the fusion chamber 103, the filament 100 is heated until it is fused and is subsequently extracted through an extrusion nozzle 104 of the printer 109; the extruded thermoplastic material 105 is thus deposited, taking on approximately, in section, the shape of the extrusion nozzle 104; the extruder 102 is moved in space, typically with three degrees of freedom, so that the deposition of the extruded thermoplastic material 105 causes the formation of a desired element, possibly by carrying out depositions of successive layers of extruded thermoplastic material 105, vertically stacked.

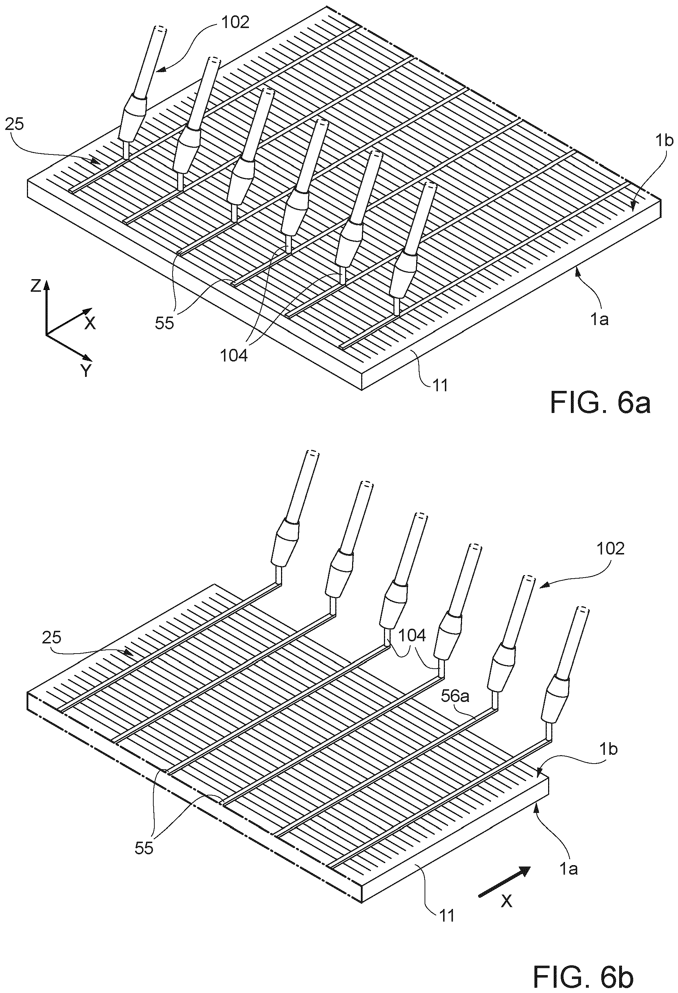

That being said, the connectors of the string 2 can be formed by iteration of cycles, each cycle comprising four consecutive steps described in detail hereinafter and shown in Figures 6a-6e, with reference to the connectors of the group to which the first connector S belongs and under the assumption that the printer 109 shown in Figure 5 is used, as well as under the assumption that the filament 100 is formed of the aforementioned composite material. Furthermore, it is assumed, without loss of generality, that the printer 109 has a number of extrusion nozzles 104 equal to the number of connectors of the group, the extrusion nozzles 104 being offset along the axis Y and being configured to perform simultaneous depositions of extruded composite material in order to simultaneously form corresponding connectors. In the following, for the sake of brevity, reference is made to the extrusion nozzle 104, which corresponds to the aforementioned first connector S.

In a first step (Figure 6a), prior to the formation of the encapsulation region 4, the first cell 11 is arranged as flipped, with respect to the Z axis, compared to what is shown in Figures 4a-4c, so that the second face 1b overlaps the first face 1a. Through the extrusion nozzle 104, the extruded composite material is laid on the second face 1b of the first cell 11 so as to form the first end portion 55 of the first connector S in the corresponding connection cavity 20b. For this purpose, it is assumed that the extrusion nozzle 104 performs a single pass, moving parallel to the axis X. The extrusion nozzle 104 is further driven to continue its movement parallel to the axis X so as to form the first lateral part 56a of the coupling portion 56 (Figure 6b), as an extension of the first end portion 55 beyond the first cell 11.

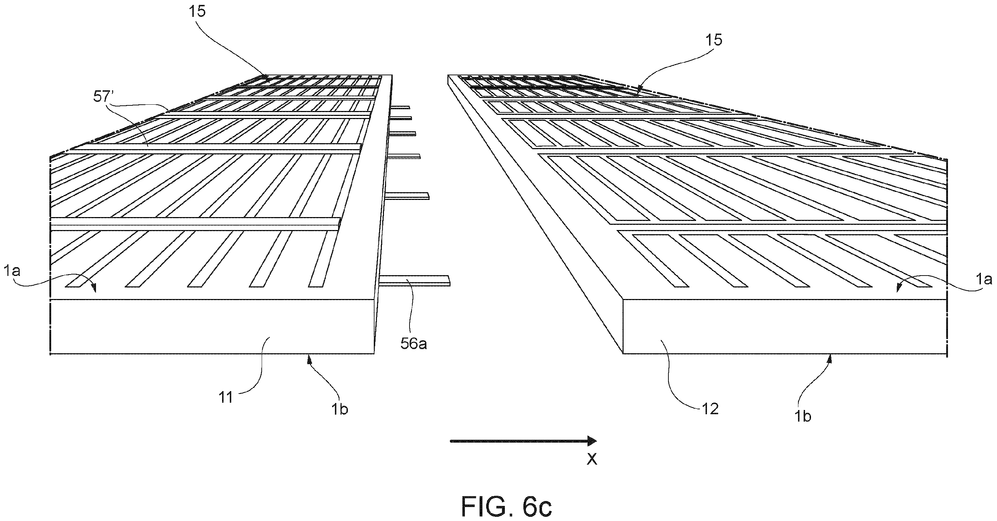

In a second step (Figure 6c), the first cell 11, together with the first end portion 55 and the first lateral part 56a of the already printed coupling portion 56, is flipped according to techniques known in the art, for example by means of a unit (not shown) for flipping the photovoltaic cells and the associated groups. Thus, the first cell 11 takes on the orientation shown in the Figures 4a-4c.

Still referring to Figure 6c, the second cell 12 is arranged, along the axis X, side by side to the first cell 11. In addition, the second cell 12 is arranged oriented as shown in Figure 4a and Figures 4d and 4e.

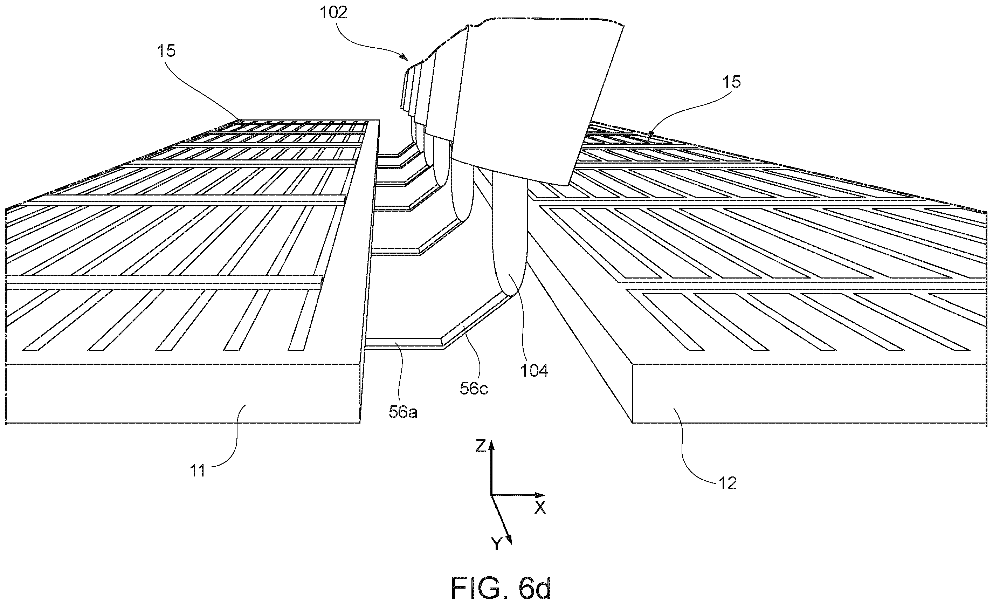

In a third step (Figure 6d) the extruder 102 is positioned so that the extrusion nozzle 104 resumes printing from the first lateral part 56a. In addition, the extrusion nozzle 104 is initially moved not only along the axis X, but also along the axis Z, so as to first print the oblique part 56c; subsequently, the extrusion nozzle 104 is moved parallel to the axis X, so as to form the second lateral part 56b (not shown in Figure 6d), according to the "S-shaped" profile described above.

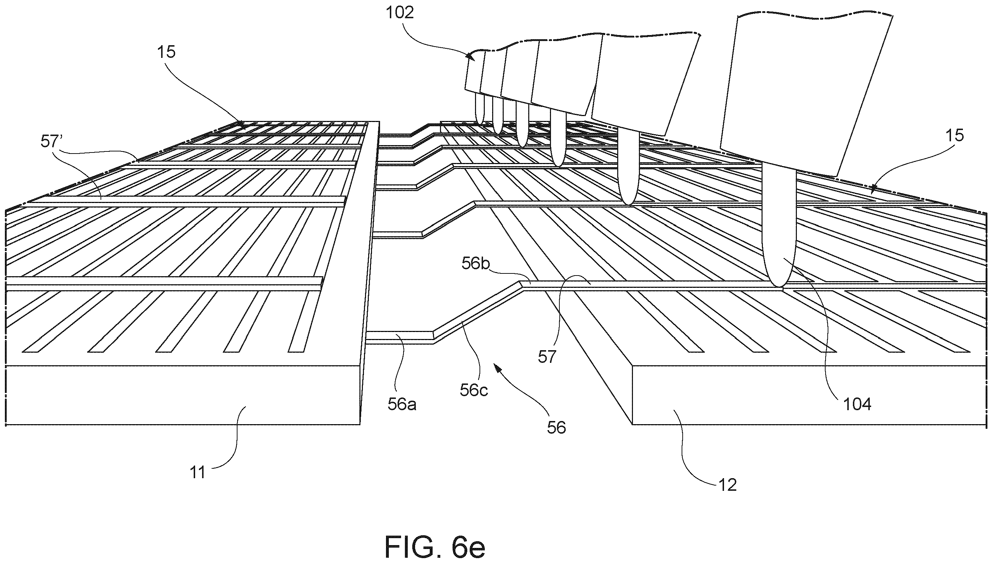

Finally, in a fourth step (Figure 6e) the extrusion nozzle 104 is driven so as to deposit the extruded composite material on the first face 1a of the second cell 12, so as to form the second end portion 57 of the first connector S in the corresponding connection cavity 20a of the second cell 12.

The above-mentioned four steps of the interconnection process between cells 1 can then be repeated, starting by flipping the group comprising the first and the second cell 11, 12 and depositing the first end portion 55'' of the third connector S" on the second face 1b of the second cell 12. In this regard, in Figure 6c it is visible, on the first cell 11, the second end portion 57' of the second connector S' deposited on the first face 1a of the first cell 11, i.e. in direct contact with the respective first conductive structure 15, and formed in the fourth step of the cycle prior to the four-step cycle that caused the formation of the first connector S.

Since the connectors are made of thermoplastic polymeric material, no activation step is required after the printing steps; in fact, when the composite material cools down - i.e. when it returns to the solid phase - following deposition, it regains its initial structural properties (those at room temperature). Furthermore, throughout the printing process, and in particular during the deposition steps on the faces of the cells 1, the temperature reached by the composite material following fusion within the fusion chamber 103 is kept in a controlled manner below the temperatures considered as critical for the type of photovoltaic cells used.

The parameterisation of the 3D printing of connectors, for example in terms of print speed and inclination of the extrusion nozzle, is performed according to the composite material used and the desired form of the connectors.

The Applicant has verified that the interconnections between photovoltaic cells made of thermoplastic polymer added with conductive particles meet the electrical conductivity requirements of photovoltaic module strings. Furthermore, as already mentioned and as is clear from the above, the present connectors allow to avoid the use of electrically conductive adhesives (ECAs) as bonding agents between the connectors and the photovoltaic cells. The direct consequence is a reduction in the electrical interfaces seen by photogenerated charge carriers in the conductive path from the semiconductor area to the connectors, with an overall benefit in the electrical contacts and thus in the interconnection conductivity.

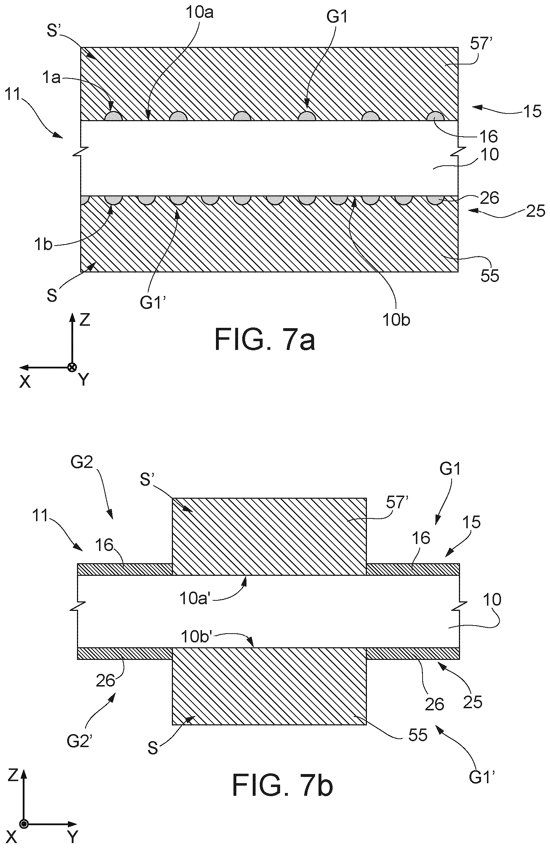

In a second embodiment, as shown in Figures 7a and 7b (wherein elements that correspond to previously described elements are indicated with the same reference numbers), the second electrodes 17, 27 are absent; in the following, the second embodiment is described referring to the differences with respect to the first embodiment.

In detail, referring to the first and second groups G1, G2 adjacent to each other of corresponding portions of first electrodes 16 (visible in Figure 7b) on the main front surface 10a of the first cell 11 and to the underlying corresponding first and second groups G1', G2' of portions of first electrodes 26 on the main rear surface 10b of the first cell 11, between the first and the second group G1, G2, an exposed portion 10a' of the main front surface 10a of the first cell 11 extends, while between the first and the second group G1', G2', an exposed portion 10b' of the main rear surface 10b of the first cell 11 extends.

The first end portion 55 of the corresponding first connector S extends below the exposed portion 10b' of the main rear surface 10b, in direct contact, so that a top portion of the first end portion 55 extends between the first and the second group G1', G2', so as to laterally contact the relative portions of first electrodes 26, while a lower part of the first end portion 55 protrudes below said portions of first electrodes 26. The second end portion 57' of the corresponding second connector S' extends over the exposed portion 10a' of the main front surface 10a, in direct contact, so that a lower part of the second end portion 57' extends between the first and the second groups G1, G2, so as to laterally contact the relative portions of first electrodes 16, while a top portion of the second end portion 57' protrudes above said portions of first electrodes 16.

Although not shown in Figures 7a and 7b, the second end portion 57 of the first connector S extends onto the main front surface 10a of the second cell 12 in the same way as described with reference to the second end portion 57' of the second connector S' and to the main front surface 10a of the first cell 11.

The embodiment shown in Figures 7a and 7b can be manufactured by performing the step cycles described and illustrated above.

The connectors of the present embodiment allow an improvement in the conductivity of electrical connections between photovoltaic cells through a reduction in electrical interfaces, in particular through the absence of electrical interfaces between first electrodes and second electrodes of each conductive structure and between second electrodes and connectors.

It is clear that changes and variations can be made to what herein described and illustrated without departing from the protection scope of the present invention, as defined in the appended claims.

For example, the composite material of the connectors can be selected or treated to reflect the light radiation incident on the photovoltaic cell, thus being able to convey, towards the conversion layer, rays that would otherwise be lost.

The form and size of the connectors may differ from those disclosed.

The main front surface and the main rear surface of the photovoltaic cells may have different profiles, in section, than those shown in the attached Figures; for example, they may have textured profiles.

The thermoplastic polymer matrix of the connectors can be formed from combinations of the monomers described above, resulting in polymers with desired chemical-physical properties, e.g. block copolymers.

The composite material may comprise, alternatively to the polymeric matrix, a metal matrix exhibiting a fusion temperature lower than 220°C, preferably lower than 200°C, even more preferably lower than 180°C. For example, the metal matrix may be formed of one or more metals or alloys, even with reduced conductivity, such as in particular bismuth, tin, lead, cadmium, calcium alloys.

The following further photovoltaic cell technologies can be used in the photovoltaic module by exploiting the manufacturing process of the present invention: monocrystalline silicon cells; polycrystalline silicon cells; BSF ("Back Surface Field") cells; PERC ("Passivated Emitter and Rear Contact") cells; PERT ("Passivated Emitter and Rear Totally Diffused") cells; TOPCon ("Tunnel Oxide Passivated Contact") cells; IBC ("Interdigitated Back-Contacted") cells.

The photovoltaic cells described above refer to full cells, such as commercially available cells with dimensions of 105×210 mm or 210×210 mm. However, the above also applies when full cells are cut into portions (or "sub-cells"); for example, a full cell may be cut in half into two equivalent portions or may be cut into three equivalent portions; such cutting is typically carried out following the formation of the conductive structures and along cutting regions, typically parallel to the direction of the first electrodes. It is understood that the manufacturing process of electrical connections between cells described above may also be employed for interconnecting, and thus assembling in strings, portions of full cells. In such a condition, a string comprises a plurality of portions of full cell, all oriented as described above, interconnected in a manner and by connectors as described above.

## Claims

1. A photovoltaic module (19) comprising at least a string (2) comprising at least a first and a second photovoltaic cell (11, 12) and a connector (S) that electrically couples the first and the second photovoltaic cell, each of the first and second photovoltaic cell comprising:
- a respective photovoltaic conversion region (10) delimited by a respective main front surface (10a) and a respective main rear surface (10b) opposite to each other; and
- a respective first electrode structure (15) and a respective second electrode structure (25), which are formed of conductive material and extend respectively on the main front surface (10a) and on the main rear surface (10b);
**characterized in that** the connector (S) is formed of a composite material comprising a support matrix and electrically conductive particles, which are dispersed in the support matrix; and wherein the connector comprises a respective first end portion (55) and a respective second end portion (57), which respectively contact the second electrode structure of the first photovoltaic cell and the first electrode structure of the second photovoltaic cell.

2. The photovoltaic module according to claim 1, wherein the support matrix has a fusion temperature lower than 220°C.

3. The photovoltaic module according to claim 1 or 2, wherein the support matrix is a thermoplastic polymer matrix.

4. The photovoltaic module according to claim 3, wherein the thermoplastic polymer matrix is formed of at least a material selected from: a polystyrene-based material; the copolymer acrylonitrile-styrene; polymethylmethacrylate; polycarbonate; polylactic acid; a natural polymer; a natural rubber; a vulcanized rubber; a chloroprene rubber; an epichlorohydrin rubber; a fluoroelastomer rubber; a hydrogenated nitrile rubber; a nitrile rubber; a perfluoroelastomer rubber; a polyacrylic rubber; a silicone rubber comprising polymers of: styrene; butadiene; olefins; esters; amides; urethane.

5. The photovoltaic module according to claim 2, wherein the support matrix is a metallic matrix.

6. The photovoltaic module according to claim 5, wherein the metallic matrix is formed of at least one metallic alloy chosen from: bismuth alloy; tin alloy; lead alloy; cadmium alloy; calcium alloy.

7. The photovoltaic module according to any one of the preceding claims, wherein the electrically conductive particles are formed of at least one conductive material chosen from: silver; copper; steel alloys; tin; tin alloys; antimony alloys; bismuth alloys; carbon compounds, such as for example graphite, graphene, carbon nanotubes.

8. The photovoltaic module according to any one of the preceding claims, further comprising an encapsulant region (4), inside which the first and second photovoltaic cell (11, 12) are arranged, coplanar with each other; and wherein the connector (S) further comprises a coupling portion (56) that connects the first and the second end portion (55, 57) and that extends into a portion of the encapsulant region interposed between the first and the second photovoltaic cell.

9. The photovoltaic module according to any one of the preceding claims, wherein each first electrode structure (15) comprises:
- at least a respective first and a respective second front group (G1, G2) of first front electrodes (16) having elongated shapes parallel to a first direction (Y) and arranged on the main front surface (10a), the first front electrodes of each of the first and second front group being offset parallel to a second direction (X), the first and the second front group (G1, G2) being offset parallel to the first direction (Y);
- at least a respective pair of second front electrodes (17) having elongated shapes parallel to the second direction (X) and arranged on the main front surface (10a), the pair of second front electrodes (17) being interposed between the first and the second front group (G1, G2) of first front electrodes (16), so that each second front electrode (17) contacts a corresponding group of said first and second front group (G1, G2) of first front electrodes (16), the pair of second front electrodes (17) laterally delimiting a corresponding front cavity (20a), which is further delimited by a corresponding exposed portion of the main front surface (10a);
and wherein each second electrode structure (25) comprises:
- at least one respective first and one respective second rear group (G1', G2') of first rear electrodes (26) having elongated shapes parallel to the first direction (Y) and arranged on the main rear surface (10b), the first rear electrodes of each of the first and the second rear group being offset parallel to the second direction (X), the first and the second rear group (G1', G2') being offset parallel to the first direction (Y);
- at least one respective pair of second rear electrodes (27) having elongated shapes parallel to the second direction (X) and arranged on the main rear surface (10b), the pair of second front electrodes (27) being interposed between the first and the second rear group (G1', G2') of first rear electrodes (26), so that each second rear electrode (27) contacts a corresponding group of said first and second rear group (G1', G2') of first rear electrodes (26), the pair of second rear electrodes (27) laterally delimiting a corresponding rear cavity (20b), which is further delimited by a corresponding exposed portion of the main rear surface (10b);
wherein the first end portion (55) of the connector (S) extends into the rear cavity (20b) of the first photovoltaic cell (11), in contact with the corresponding second rear electrodes (27) and with the corresponding exposed portion of the main rear surface (10b) of the first photovoltaic cell (11); and wherein the second end portion (57) of the connector (S) extends into the front cavity (20a) of the second photovoltaic cell (12), in contact with the corresponding second front electrodes (17) and with the corresponding exposed portion of the main front surface (10a) of the second photovoltaic cell (12).

10. The photovoltaic module according to any one of the preceding claims from 1 to 8, wherein each first electrode structure (15) comprises:
- at least one respective first and one respective second front group (G1, G2) of first front electrodes (16) having elongated shapes parallel to a first direction (Y) and arranged on the main front surface (10a), the first front electrodes of each of the first and the second front group being offset parallel to a second direction (X), the first and the second front group (G1, G2) being offset parallel to the first direction (Y), so as to expose a corresponding portion (10a') of the corresponding main front surface (10a);
and wherein each second electrode structure (25) comprises:
- at least one respective first and one respective second rear group (G1', G2') of first rear electrodes (26) having elongated shapes parallel to the first direction (Y) and arranged on the main rear surface (10b), the first rear electrodes of each of the first and the second rear group being offset parallel to the second direction (X), the first and the second rear group (G1', G2') being offset parallel to the first direction (Y), so as to expose a corresponding portion (10b') of the corresponding main rear surface (10b);
and wherein the first terminal portion (55) of the connector (S) has an elongated shape parallel to the second direction (X) and extends on the exposed portion (10b') of the main rear surface (10b) of the first photovoltaic cell (11), in contact with the corresponding first and second rear group (G1', G2') of first rear electrodes (26); and wherein the second end portion (57) of the connector (S) has an elongated shape parallel to the second direction (X) and extends on the exposed portion (10a') of the main front surface (10a) of the second photovoltaic cell (12), in contact with the corresponding first and second front group (G1, G2) of first front electrodes (16).

11. The photovoltaic module according to any one of the preceding claims, wherein the first and the second photovoltaic cell (11, 12) are heterojunction photovoltaic cells.

12. A manufacturing process of a photovoltaic module (19) comprising forming at least one string (2) comprising at least a first and a second photovoltaic cell (11, 12) and a connector (S) that electrically couples the first and the second photovoltaic cell, each of the first and second photovoltaic cell comprising:
- a respective photovoltaic conversion region (10) delimited by a respective main front surface (10a) and a respective main rear surface (10b) opposite to each other; and
- a respective first electrode structure (15) and a respective second electrode structure (25), which are formed of conductive material and extend respectively on the main front surface (10a) and on the main rear surface (10b);
**characterized in that** the connector (S) is formed of a composite material comprising a support matrix and electrically conductive particles, which are dispersed in the support matrix; and wherein the connector comprises a respective first end portion (55) and a respective second end portion (57), which respectively contact the second electrode structure of the first photovoltaic cell and the first electrode structure of the second photovoltaic cell.

13. The manufacturing process according to claim 12, wherein forming at least one string (2) comprises forming the connector (S) through a fused deposition modelling process.

14. The manufacturing process according to claim 12 or 13, wherein the support matrix has a fusion temperature lower than 220°C.
